# EUROPEAN PATENT SPECIFICATION

(11) **EP 2 811 304 B1**
(45) Date of publication and mention of the grant of the patent: **27.07.2016**
(21) Application number: 14170256.3
(22) Date of filing: 28.05.2014
(51) Int. Cl.: G01R 1/067, G01R 31/28

(54) **Circuit board inspection method, circuit board inspection apparatus and circuit board inspection tool**
Leiterplattenprüfverfahren, Leiterplattenprüfvorrichtung und Leiterplattenprüfwerkzeug
Procédé, appareil et outil d'inspection de carte de circuit imprimé

(30) Priority: 04.06.2013 JP 2013117746
(43) Date of publication of application: 10.12.2014
(73) Proprietor: Nidec-Read Corporation, Kyoto-shi, Kyoto 615-0854 (JP)
(72) Inventor: Matsuoka, Shinji, Kyoto 615-0854 (JP)
(74) Representative: Viering, Jentschura & Partner mbB Patent- und Rechtsanwälte

(56) References cited:
- JP-A- H11 202 016
- US-A- 5 831 441
- US-A- 5 907 245

## Description

### BACKGROUND OF THE INVENTION

### 1. Field of the Invention

The present invention relates to a circuit board inspection method of performing electrical inspection of writing patterns formed on a circuit board or a substrate with a built-in electronic component (or IC, etc.), and a circuit board inspection tool and a circuit board inspection apparatus used in the circuit board inspection method.

### 2. Description of the Related Art

Currently, there has been widespread a circuit board with a built-in electronic component (or an embedded substrate) in which an electronic component including a diode and a capacitor is built. There are proposed various types of inspection methods of inspecting the circuit board with the built-in electronic component. For example, there are inspection methods as disclosed in Patent document 1, Patent document 2, JP H11 202016A, US 5 831 441 A and US 5 907 245 A. In the technologies disclosed in the Patent document 1 and the Patent document 2, there are disclosed a method of setting a test point to inspect the electronic component built in the circuit board.

By the way, in the actual inspection of the embedded substrate, test points (or inspection points) are set in wiring patterns formed on the surface of the circuit board, and contactors (or probes) conductively connected to a circuit board inspection apparatus are brought into contact with the inspection points to electrically connect the circuit board inspection apparatus and the wiring patterns. By this, electrical signals are transmitted or received. Thus, a circuit board inspection tool is used to electrically connect the embedded substrate and the circuit board inspection apparatus.

What is important in the case where the quality of the wiring pattern on the embedded substrate as described above is to perform the electrical inspection without damaging the electronic component built in the circuit board. In the case where the circuit board is inspected, an electric charge (or stray capacitance) of the circuit board is discharged to cause excess current, and there is a risk of damaging the electronic component built in the circuit board. In particular, the circuit board inspection apparatus configured to inspect the circuit board has such a problem that the excess current as described above easily occurs because the circuit board is mounted on an inspection table while the circuit board is floated with respect to a ground or an earth.

Patent Document 1: Japanese Patent Application Laid Open No. 2006-11507
Patent Document 2: Japanese Patent Application Laid Open No. 2009-276861

### SUMMARY OF THE INVENTION

It is therefore an object of the present invention to provide a circuit board inspection method, a circuit board inspection apparatus and a circuit board inspection tool, which prevent the occurrence of the excess current due to the electric charge of the circuit board and which prevent the damage of the electronic component, in the case of inspecting the circuit board with the built-in electronic component, such as the embedded substrate.

The invention according to claim 1 provides a circuit board inspection method.

The invention according to claim 6 provides a circuit board inspection.

According to the invention, it is a circuit board inspection method of inspecting wiring patterns on a circuit board with a built-in electronic component by using a circuit board inspection apparatus configured to perform electrical inspection of the wiring patterns formed on the circuit board and a circuit board inspection tool configured to electrically connect the circuit board and the circuit board inspection apparatus. Firstly, a wiring pattern electrically connected to the electronic component of the circuit board is grounded via the circuit board inspection tool. Then, all the wiring patterns formed on the circuit board are set in conductive contact with the circuit board inspection apparatus via the circuit board inspection tool. Then, the electrical inspection of the circuit board is performed. It is thus possible to prevent the excess current due to the stray capacitance of the circuit board or the like from flowing into the electronic component and damaging the electronic component.

According to the invention, after the electrical inspection is performed, the circuit board inspection tool is separated from the circuit board in a state in which all the wiring patterns are grounded via the circuit board inspection tool. It is thus possible to prevent the damage of the electronic component due to separation discharge which occurs in the case where the circuit board inspection tool is separated from the circuit board.

According to the invention, it is a circuit board inspection tool configured to electrically connect a circuit board with a built-in electronic component and a circuit board inspection apparatus configured to inspect a plurality of wiring patterns formed on the circuit board, wherein an amount of projection of a contactor which abuts on an inspection point of a wiring pattern conductively connected to the electronic component is formed to be greater than an amount of projection of the other contactors. Thus, when the circuit board inspection tool grips the circuit board, firstly, the contactor having a large amount of projection abuts on the circuit board as the inspection object. It is thus possible to prevent the excess current, which damages the electronic component, from flowing into the electronic component.

According to the invention, the amount of projection of the contact is set to be longer than the amount of projection of the other contactors, by a length which is the sum of a size accuracy amount of the contactors and a deflection amount of the circuit board. Thus, when the circuit board inspection tool grips the circuit board, this contactor certainly abuts on the inspection point before the other contacts do.

According to the invention, the wiring pattern connected to the electronic component is connected to a GND terminal of the electronic component. It is thus possible to protect the electronic component from the excess current, more certainly.

According to the invention, it is a circuit board inspection apparatus configured to inspect a plurality of wiring patterns formed on a circuit with a built-in electronic component, the circuit board inspection apparatus provided with: the circuit board inspection tool for conductively connecting a wiring pattern of the circuit board as an inspection object and the circuit board inspection apparatus; a moving mechanism for making the circuit board inspection tool abut on the circuit board; an inspecting device for inspecting electrical characteristics of the wiring pattern; and a controlling device for controlling the moving mechanism and the inspecting device, wherein the controlling device activates the moving mechanism to make the circuit board inspection tool abut on the circuit board, and activates the inspecting device to ground the contactor which is in contact with the wiring pattern electrically connected to the electronic component. Thus, in the case where the circuit board is gripped by the circuit board inspection tool, it is possible to prevent the excess current due to the stray capacitance of the circuit board or the like from flowing into the electronic component and damaging the electronic component.

### BRIEF DESCRIPTION OF THE DRAWINGS

FIG. 1 is a schematic cross sectional view illustrating an embodiment of a circuit board as an inspection object of the present invention;
FIG. 2 is a cross sectional view of a schematic side view illustrating a circuit board inspection apparatus of the present invention;
FIG. 3 is a schematic side view illustrating a circuit board inspection tool of the present invention; and
FIG. 4 is a schematic enlarged view illustrating a dashed-line portion a of the circuit board inspection tool illustrated in FIG. 3.

### DETAILED DESCRIPTION OF THE PREFERRED EMBODIMENT

The best mode for carrying out the present invention will be explained.

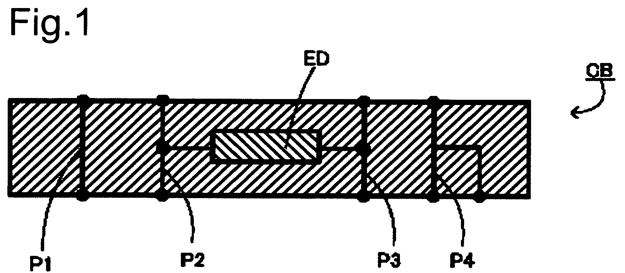

A circuit board or a substrate as an inspection object of the present invention will be briefly explained. FIG. 1 is a schematic cross sectional view illustrating the circuit board as the inspection object of the present invention. The circuit board as the inspection object of the present invention is a circuit board referred to a so-called embedded substrate, and is characterized in that an electronic component is built inside the circuit board. In a circuit board CB illustrated in FIG. 1, four wiring patterns P (P1 to P4) and an electronic component ED are illustrated, and a wiring pattern P2 and a wiring pattern P3 are connected to the electronic component ED. The wiring pattern P2 is conductively connected to a GND terminal of the electronic component ED.

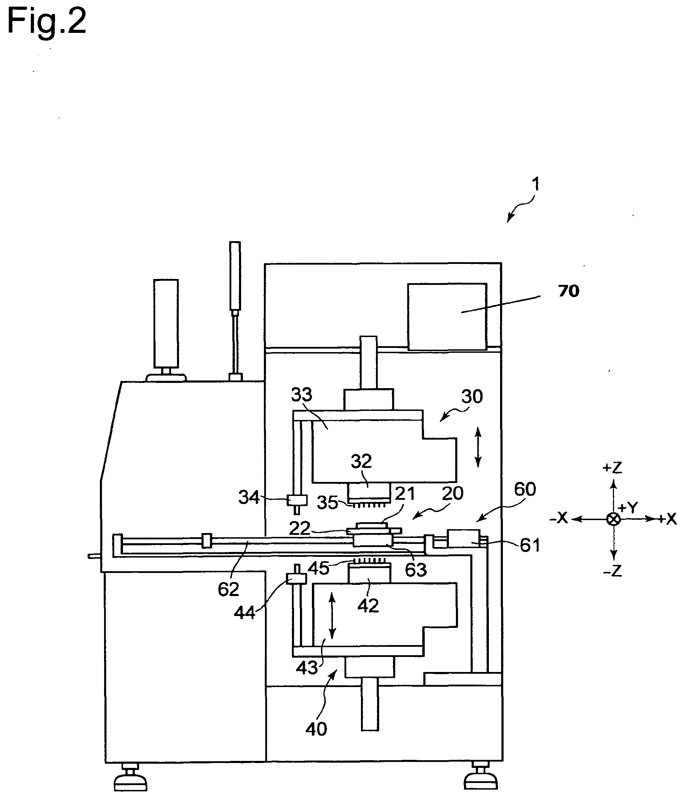

Next, a circuit board inspection apparatus 1 for inspecting the circuit board used in the present invention will be briefly explained. FIG. 2 is a structural cross sectional view illustrating a circuit board inspection apparatus 1 in an embodiment of the present invention. FIG. 2 illustrates a rectangular coordinate system using XYZ axes, from the viewpoint of clarifying moving directions of a conveying table 20 and first and second inspection tool moving units 30 and 40. The Y axis has a positive direction which is directed from the front side to the back side of the paper of FIG. 1.

The circuit board inspection apparatus 1 is provided with a circuit board moving unit 60 for moving the conveying table 20 along the X axis, and the first and second inspection tool moving units 30 and 40 for moving, in a YZ surface, inspection tools 32 and 42 on which a plurality of probes (or contactors) 35 and 45 for circuit board inspection are mounted. The first and second inspection tool moving units 30 and 40 are arranged symmetrically with respect to a XY surface. The details of the inspection tools will be explained later, and the inspection tools will have reference numerals of 32 and 42 in the explanation of the configuration of the circuit board inspection apparatus 1.

The conveying table 20 is provided with a circuit board holding unit 22 for mounting an inspection circuit board 21 thereon, and a cylinder bracket 63 fixed on a bottom surface of the inspection circuit board 21. The cylinder bracket 63 has a screw hole formed, wherein the screw hole pierces through the cylinder bracket 63 in a longitudinal direction.

The circuit board moving unit 60 is provided with a ball screw 62 configured to engage with the screw hole of the bracket 63, and a drive unit 61 configured to rotate the ball screw 62. The screw thread and the thread groove on the ball screw 62 are not illustrated for simplification. If the ball screw 62 is rotated by the drive unit 61, the amount of movement and the moving directions along the X axis of the bracket 63, i.e. the conveying table 20, are determined depending on the amount and the direction of rotation of the ball screw 62.

The first inspection tool moving unit 30 is provided with an inspection tool holding unit 33. The inspection tool holding unit 33 functions as holding the inspection tool 32 on which the plurality of probes 35 for circuit board inspection are mounted, and functions as moving the inspection tool 32 to make the plurality of probes 35 for circuit board inspection abut on inspection points of wires as the inspection objects on the inspection circuit board 21. The plurality of probes 35 for circuit board inspection and the like are electrically connected to a scanner (not illustrated) for inspecting and measuring the circuit board, via the inspection tool holding unit 33.

The second inspection tool moving unit 40 is provided with an inspection tool holding unit 43, as in the inspection tool holding unit 33 of the first inspection tool moving unit 30. The inspection tool holding unit 43 functions as in the inspection tool holding unit 33.

The movement of the first and second inspection tool moving units 30 and 40 and the circuit board moving unit 60 is controlled by a control apparatus (not illustrated) of the circuit board inspection apparatus 1. The first and second inspection tool moving units 30 and 40 have main cameras 34 and 44 installed, respectively, in order to specify the positions of the inspection circuit board 21 (or a sheet substrate B) and the conveying table 20.

The circuit board inspection apparatus 1 has an inspecting device 70 for performing the electrical inspection of the circuit board CB. The inspecting device 70 has a configuration necessary for the electrical inspection of the circuit board CB. For example, the inspecting device 70 has an electric power supply unit (not illustrated) configured to perform continuity or conduction inspection of a wiring pattern, a detection unit (not illustrated) configured to detect an electrical signal from the wiring pattern, a determination unit (not illustrated) configured to process and determine a detected signal from the detection unit, a change unit or a switching unit (not illustrated) configured to change a conduction pathway from a contactor, to each unit, and the like. The inspecting device 70 can be configured, for example, by adopting a direct current or alternating current power supply, an ammeter, a voltmeter, a switching element, and the like.

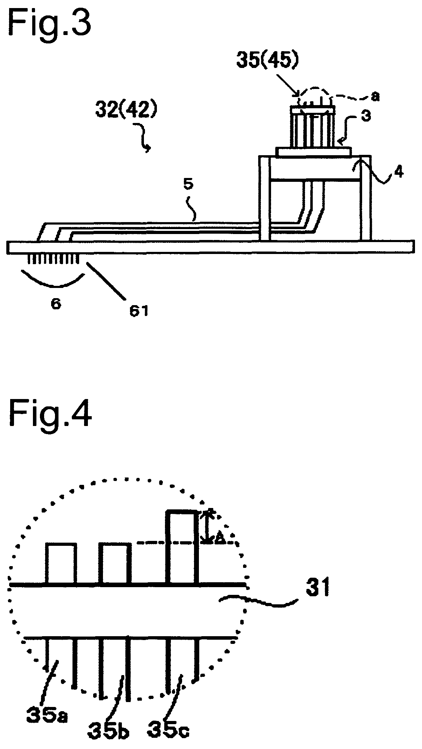

Next, the inspection tool 32 or 42 used on the circuit board inspection apparatus 1 will be explained. FIG. 3 illustrates an embodiment of the circuit board inspection tool. The inspection tool 32 has the plurality of contactors 35 or 45, a holding body or a support body 3 configured to hold the contactors in a multi-needle manner, an electrode body 4 having electrode units configured to support the holding body 3 and configured to be in contact with the contactors 35 to be conductive to the circuit board inspection apparatus 1, a conducting wire unit 5 extended from and electrically connected to the electrode units, and a connection body 6 having connecting units 61 electrically connected to the circuit board inspection apparatus 1. FIG. 3 is a schematic side view for explaining the outline of the circuit board inspection tool 32. FIG. 3 illustrates three contactors 35, but the number of the contactors 35 is not particularly limited to this example.

Each of the contactors 35 electrically connects the inspection point set in the wiring pattern P and respective one of the electrode units described later. The contactor 35 abuts on the inspection point at one end, and abuts on the electrode unit at the other end. Due to the contactor 35, the inspection point and the electrode unit are electrically connected. The contactor 35 is formed, for example, in an elongated rod shape, and can adopt a member having conductivity and flexibility. Moreover, the contactor 35 can also adopt a member using a spring which extends and contracts in the longitudinal direction.

The electrode body 4 holds the electrode units (not illustrated) on which the contactors 35 abut at the other end and which are electrically connected to the circuit board inspection apparatus 1. The electrode units are formed to be substantially flush with the surface of the electrode body 4. Each of the electrode unit is preferably formed to be slightly greater than an outer diameter of respective one of the contactors 35.

The conducting wire unit 5 electrically connects the electrode units of the electrode body 4 and the connecting units 61 of the connection body 6 described later. The conducting wire unit 5 is only required to electrically connect the electrode units 41 and the connecting units 61, and can adopt a linear metal wire such as, for example, a copper wire.

If the conducting wire unit 5 is prepared by using the metal wire, the electrode body 4 is provided with through holes to place respective conducting wires in the through holes, and the conducting wires are cut to be flush with the surface of the electrode body 4. By this, the electrode units can be formed. In this case, one ends of the metal wires function as the electrode units, and the other ends of the metal wires are conductively connected to the connecting units 61.

The connection body 6 holds the connecting units 61 electrically connected to the circuit board inspection apparatus 1. Each of the connecting units 61 is conductively connected to a connection point of the circuit board inspection apparatus 1, thereby being electrically connected to the circuit board inspection apparatus 1. The connection can adopt, for example, connector connection formed in an uneven shape (or in a concave and convex shape)

The holding body 3 holds the contactors 35, guides one ends of the contactors 35 to the inspection points and guides the other ends of the contactors 35 to the electrode units. The holding body 3 in FIG. 3 is formed of two plate-like members disposed at a predetermined interval, and can bend the contactors 35 in a space formed by the two plate-like members.

FIG. 4 is a partial enlarged view illustrating the circuit board inspection tool illustrated in FIG. 3. The embodiment in FIG. 4 illustrates a state of the contactors 35 projecting from a plate-like member 31 on the upper side of the holding body 3. The circuit board inspection tool 3 in FIG. 4 has a contactor 35c which abuts on the inspection point on the wiring pattern conductively connected to the electronic component ED, a contactor 35a and a contactor 35c which abut on the inspection points on the wiring patterns not conductively connected to the electronic component ED.

In the circuit board inspection tool 32, the amount of projection of the contactor 35c which abuts on the inspection point of the wiring pattern P conductively connected to the electronic component ED is formed to be greater than the amount of projection of the other contactors 35a and 35b (refer to FIG. 4). Thus, if the circuit board inspection apparatus 1 moves the circuit board inspection tool 32, the contactor 35c firstly abuts on the inspection point of the circuit board CB. After that, the contactors 35a and 35b abut on the inspection points of the circuit board CB.

The amount of projection of the contactor 35c which abuts on the wiring pattern P conductively connected to the electronic component ED is set to be longer than the amount of projection of the other contactors 35a and 35b, by a length A which is the sum of a size accuracy amount of the contactors 35 and a deflection amount of the circuit board. Due to the formation of the contactor 35c to be longer by the length A, in the case where the circuit board inspection tool 32 grips the circuit board CB, the contactor 35c can certainly abut on the circuit board CB before the other contactors 35 do, because the contactor 35c projects by the length A.

In the circuit board inspection tool 32, as described above, the contactor 35c which abuts on the inspection point of the wiring pattern P conductively connected to the electronic component ED is disposed to be longer (or to project) by the length A; however, the contactor 35c set to be longer by the length A can be also set in the wiring pattern P which is connected to the GND terminal of the electrode component ED. Due to the setting of the contactor 35c in the wiring pattern P which is connected to the GND terminal of the electrode component ED, the damage of the electronic component ED can be prevented, more certainly.

The above is the explanation of the configuration of the circuit board inspection apparatus and the inspection tool of the present invention.

Next, the circuit board inspection method of the present invention will be explained.

Firstly, the circuit board CB as the inspection object is set. At this time, the contactor 35 which abuts on the inspection point set in the wiring pattern P conductively connected to the electronic component ED of the circuit board CB as the inspection object is specified. The specified contactor 35 is set such that the amount of projection from the plate-like member of the holding body 3 is longer by a predetermined length A than that of the contactors 35 which abut on the inspection points set in the wiring patterns P not conductively connected to the electronic component ED (or the other contactors 35). The upper-side circuit board inspection tool 32 and the lower-side circuit board inspection tool 42 are prepared depending on the inspection points of the circuit board CB.

If the circuit board CB as the inspection object is prepared on the circuit board inspection apparatus 1, the inspection is started. The circuit board CB is gripped by the upper-side circuit board inspection tool 32 and the lower-side circuit board inspection tool 42. At this time, in the upper-side circuit board inspection tool 32 or the lower-side circuit board inspection tool 42, the contactor 35 or 45 which abuts on the wiring pattern P (or the wiring pattern P2 in FIG. 1) conductively connected to the electronic component ED is formed to be longer by the predetermined length A. Incidentally, in the case of the circuit board CB in FIG. 1, four contactors 35 are disposed in the upper-side circuit board inspection tool 32, and five contactors 35 are disposed in the lower-side circuit board inspection tool 42. Here, the contactor which abuts on the wiring pattern P2 connected to the GND terminal of the electronic component ED is disposed to project by the length A.

The circuit board inspection apparatus 1 moves each of the upper-side circuit board inspection tool 32 and the lower-side circuit board inspection tool 42 to abut on the surface of the circuit board CB. At this time, the circuit board inspection apparatus 1 performs switching to ground the contactor 35 or 45 connected to the wiring pattern P2 connected to the electronic component ED. Thus, the contactors abut on the circuit board CB in a grounded state.

Moreover, in the upper-side circuit board inspection tool 32 or the lower-side circuit board inspection tool 42, the contactor 35 or 45 conductively connected to the electronic component ED firstly abuts on the inspection point of the circuit board CB. At this time, even if there is stray capacitance in the circuit board CB itself, electricity is discharged from the circuit board inspection apparatus 1 via the circuit board inspection tool 32 or 42, and the damage of the electronic component ED of the circuit board ED can be thus prevented. The circuit board inspection apparatus 1 moves the upper-side circuit board inspection tool 32 and the lower-side circuit board inspection tool 42 until the circuit board CB can be gripped (or until all the contactors abut on the inspection points).

If the circuit board inspection apparatus 1 sets each of the upper-side circuit board inspection tool 32 and the lower-side circuit board inspection tool 42 on the circuit board CB, the electrical inspection is performed on each of the wiring patterns P.

If the electrical inspection ends, all the wiring patterns P of the circuit board CB are grounded by the circuit board inspection apparatus 1 via the circuit board inspection tool 32 or 42, and in this state, the circuit board inspection apparatus 1 moves the upper-side circuit board inspection tool 32 and the lower-side circuit board inspection tool 42 to be separated from the circuit board CB. As described above, due to the movement of the circuit board inspection apparatus 1, it is possible to prevent the damage of the electronic component ED due to the occurrence of the excess current caused by the separation discharge which occurs in the case where the circuit board inspection tools are separated from the circuit board.

As described above, in the present invention, it is possible to protect the electronic component ED from the discharge caused by that the circuit board inspection tools abutting on and being separated from the circuit board CB, and it is possible to prevent the damage of the electronic component ED by the inspection.

### < Description of Reference Numerals >

- 1: circuit board inspection apparatus
- 32 (42): circuit board inspection tool
- 35 (45): contactor
- A: predetermined length
- CB: circuit board

## Claims

1. A circuit board inspection method of inspecting wiring patterns (P1, P2, P3, P4) on a circuit board (CB) with a built-in electronic component (ED) by using a circuit board inspection apparatus (1) configured to perform electrical inspection of the wiring patterns (P1, P2, P3, P4) formed on the circuit board (CB) and a circuit board inspection tool (32, 42) comprising a plurality of contactors (35a, 35b, 35c) for electrically connecting the circuit board (CB) and the circuit board inspection apparatus, said circuit board inspection method comprising the steps of:
grounding a wiring pattern (P2) electrically connected to the electronic component of the circuit board (CB) via a contactor (35c) of the plurality of contactors of the circuit board inspection tool (32, 42), wherein an amount of projection of the contactor (35c) is formed to be greater than an amount of projection of the other contactors (35a, 35b) of the plurality of contactors;
setting all wiring patterns (P1, P3, P4) other than the grounded wiring pattern (P2) of the wiring patterns (P1, P2, P3, P4) formed on the circuit board (CB) in conductive contact with the circuit board inspection apparatus (1) via the other contactors (35a, 35b) of the circuit board inspection tool (32,42); and
transmitting and receiving an electrical signal from the circuit board inspection apparatus (1), to and from the circuit board (CB) via the circuit board inspection tool (1), thereby performing the electrical inspection of the circuit board (CB).

2. The circuit board inspection method according to claim 1 further comprising the steps of:
after the electrical inspection is performed, grounding all the wiring patterns formed (P1, P2, P3, P4) on the circuit board (CB), by the circuit board inspection apparatus (1) via the plurality of contactors (35a, 35b, 35c) of the circuit board inspection tool (32, 42); and
separating the circuit board inspection tool (1) from the circuit board (CB) in a state in which the plurality of contactors (35a, 35b, 35c) are grounded.

3. A circuit board inspection tool (32,42) configured to electrically connect a circuit board (CB) with a built-in electronic component (ED) and a circuit board inspection apparatus (1) configured to inspect a plurality of wiring patterns (P1, P2, P3, P4) formed on the circuit board (CB), said circuit board inspection tool (32, 42) comprising:
a plurality of contactors (35a, 35b, 35c) which abut on inspection points on the wiring patterns, at one end;
an electrode body (4) having electrode units on which the respective contactors (35a, 35b, 35c) abut at the other end and which are electrically connected to the circuit board inspection apparatus (1); and
a holding body (3) having an inspection-side holding unit configured to guide one ends of the contactors (35a, 35b, 35c) to the inspection points and an electrode-side holding unit configured to guide the other ends of the contactors to the electrode units; wherein
an amount of projection of a contactor (35c) which abuts in a grounded state on an inspection point of a wiring pattern (P2) conductively connected to the electronic component (ED) is formed to be greater than an amount of projection of the other contactors (35a, 35b) such that the contactor (35c) abuts on the inspection point before the other contactors (35a, 35b) abut on the other inspection points.

4. The circuit board inspection tool according to claim 3, wherein the amount of projection of the contact (35c) is set to be longer than the amount of projection of the other contactors (35b, 35c), by a length which is the sum of a size accuracy amount of the contactors (35a, 35b, 35c) and a deflection amount of the circuit board (CB).

5. The circuit board inspection tool according to claim 3 or 4, wherein the wiring pattern (P2) connected to the electronic component (ED) is connected to a GND terminal of the electronic component (ED).

6. A circuit board inspection apparatus (1) configured to inspect a plurality of wiring patterns (P1, P2, P3, P4) formed on a circuit board (CB) with a built-in electronic component (ED), said circuit board inspection apparatus (1) comprising:
a circuit board inspection tool (32,42) according to claim 3 or 4 for conductively connecting a wiring pattern (P1, P2, P3, P4) of the circuit board (CB) as an inspection object and the circuit board inspection apparatus (1);
a moving mechanism (30, 40) for making the circuit board inspection tool (32, 42) abut on the circuit board (CB);
an inspecting device (70) for inspecting electrical characteristics of the wiring pattern (P1, P2, P3, P4); and
a controlling device for controlling the moving mechanism (30, 40) and the inspecting device (70), wherein
the controlling device activates the moving mechanism (30, 40) to make the circuit board inspection tool (32, 42) abut on the circuit board (CB), and activates the inspecting device (70) to ground the contactor (35c) which is in contact with the wiring pattern (P2) electrically connected to the electronic component (ED).

## Patentansprüche

1. Ein Leiterplattenprüfverfahren zum Prüfen von Verdrahtungsmustern (P1, P2, P3, P4) auf einer Leiterplatte (CB) mit einem eingebauten elektronischen Bauteil (ED) durch Verwenden einer Leiterplattenprüfvorrichtung (1), die ausgebildet ist, um eine elektrische Prüfung der auf der Leiterplatte (CB) gebildeten Verdrahtungsmuster (P1, P2, P3, P4) durchzuführen, und eines Leiterplattenprüfwerkzeuges (32, 42), welches eine Mehrzahl von Schützen (35a, 35b, 35c) zum elektrischen Verbinden der Leiterplatte (CB) und der Leiterplattenprüfvorrichtung aufweist, wobei das Leiterplattenprüfverfahren die Schritte aufweist:
Erden eines Verdrahtungsmusters (P2), welches elektronisch mit dem elektronischen Bauteil der Leiterplatte (CB) verbunden ist, mittels eines Schützes (35c) der Mehrzahl von Schützen des Leiterplattenprüfwerkzeugs (32, 42), wobei ein Projektionsbetrag des Schützes (35c) größer gebildet ist als ein Projektionsbetrag der anderen Schütze (35a, 35b) der Mehrzahl von Schützen,
In-leitfähigen-Kontakt-Bringen aller Verdrahtungsmuster (P1, P3, P4), außer dem geerdeten Verdrahtungsmuster (P2) der Verdrahtungsmuster (P1, P2, P3, P4), die auf der Leiterplatte (CB) gebildet sind, mit der Leiterplattenprüfvorrichtung (1) mittels der anderen Schütze (35a, 35b) des Leiterplattenprüfwerkzeugs (32, 42), und
Übertragen und Empfangen eines elektrischen Signals von der Leiterplattenprüfvorrichtung (1) zu und von der Leiterplatte (CB) mittels des Leiterplattenprüfwerkzeugs (1), und dadurch Durchführen der elektrischen Prüfung der Leiterplatte (CB).

2. Das Leiterplattenprüfverfahren gemäß Anspruch 1, ferner aufweisend die Schritte:
nach Durchführen der elektrischen Prüfung, Erden aller auf der Leiterplatte (CB) gebildeten Verdrahtungsmuster (P1, P2, P3, P4) durch die Leiterplattenprüfvorrichtung (1) mit Hilfe der Mehrzahl von Schützen (35a, 35b, 35c) des Leiterplattenprüfwerkzeugs (32, 42), und
Trennen des Leiterplattenprüfwerkzeugs (1) von der Leiterplatte (CB) in einem Zustand, in dem die Mehrzahl von Schützen (35a, 35b, 35c) geerdet sind.

3. Ein Leiterplattenprüfwerkzeug (32, 42), das ausgebildet ist, um eine Leiterplatte (CB) mit einem eingebauten elektronischen Bauteil (ED) und eine Leiterplattenprüfvorrichtung (1), die zum Prüfen einer Mehrzahl von auf der Leiterplatte (CB) gebildeten Verdrahtungsmustern (P1, P2, P3, P4) ausgebildet ist, elektrisch zu verbinden, wobei das Leiterplattenprüfwerkzeug (32, 42) aufweist:
eine Mehrzahl von Schützen (35a, 35b, 35c), welche an einem Ende an Prüfpunkte auf den Verdrahtungsmustern anstoßen,
einen Elektrodenkörper (4), welcher Elektrodeneinheiten hat, an die die jeweiligen Schütze (35a, 35b, 35c) an dem anderen Ende anstoßen und die elektrisch mit der Leiterplattenprüfvorrichtung (1) verbunden sind, und
einen Haltekörper (3), der eine Prüfseiten-Halteeinheit, welche ausgebildet ist, um eine Enden der Schütze (35a, 35b, 35c) zu den Prüfpunkten zu führen und eine Elektrodenseite-Halteeinheit aufweist, die ausgebildet ist, um die anderen Enden der Schütze zu den Elektrodeneinheiten zu führen, wobei
ein Projektionsbetrag eines Schützes (35c), welcher in einem geerdeten Zustand an einen Prüfpunkt eines Verdrahtungsmusters (P2), das leitfähig mit dem elektronischen Bauteil (ED) verbunden ist, anstößt, größer gebildet ist als ein Projektionsbetrag der anderen Schütze (35a, 35b), sodass der Schütz (35c) an dem Prüfpunkt anstößt, bevor die anderen Schütze (35a, 35b) an den anderen Prüfpunkten anstoßen.

4. Das Leiterplattenprüfwerkzeug gemäß Anspruch 3, wobei der Projektionsbetrag des Kontakts (35c) festgelegt ist, länger als der Projektionsbetrag der anderen Schütze (35b, 35c) zu sein, um eine Länge, die die Summe eines Maßhaltigkeitsbetrags der Schütze (35a, 35b, 35c) und eines Biegebetrages der Leiterplatte (CB) ist.

5. Das Leiterplattenprüfwerkzeug gemäß Anspruch 3 oder 4, wobei das Verdrahtungsmuster (P2), das mit dem elektrischen Bauteil (ED) verbunden ist, mit einem Masse-Anschluss des elektrischen Bauteils (ED) verbunden ist.

6. Eine Leiterplattenprüfvorrichtung (1), ausgebildet zum Prüfen einer Mehrzahl von Verdrahtungsmustern (P1, P2, P3, P4), die auf einer Leiterplatte (CB) mit einem eingebauten elektronischen Bauteil (ED) gebildet sind, wobei die Leiterplattenprüfvorrichtung (1) aufweist:
ein Leiterplattenprüfwerkzeug (32, 42) gemäß Anspruch 3 oder 4, um ein Verdrahtungsmuster (P1, P2, P3, P4) der Leiterplatte (CB) als ein Prüfobjekt und die Leiterplattenprüfvorrichtung (1) leitfähig zu verbinden,
einen Bewegungsmechanismus (30, 40) um das Leiterplattenprüfwerkzeug (32, 42) zu veranlassen, an die Leiterplatte (CB) anzustoßen,
eine Prüfvorrichtung (70) zum Prüfen elektrischer Merkmale des Verdrahtungsmusters (P1, P2, P3, P4), und
eine Steuervorrichtung zum Steuern des Bewegungsmechanismus (30, 40) und der Prüfvorrichtung (70), wobei
die Steuervorrichtung den Bewegungsmechanismus (30, 40) aktiviert, um das Leiterplattenprüfwerkzeug (32, 42) zu veranlassen an die Leiterplatte (CB) anzustoßen, und die Prüfvorrichtung (70) aktiviert, um den Schütz (35c) zu erden, der mit dem Verdrahtungsmuster (P2) in Kontakt ist, das elektronisch mit dem elektronischen Bauteil (ED) verbunden ist.

## Revendications

1. Procédé d'inspection de carte de circuit pour inspecter des motifs de câblage (P1, P2, P3, P4) sur une carte de circuit (CB) avec un composant électronique (ED) intégré en utilisant un appareil d'inspection de carte de circuit (1) configuré pour effectuer l'inspection électrique des motifs de câblage (P1, P2, P3, P4) formés sur la carte de circuit (CB) et un outil d'inspection de carte de circuit (32, 42) comprenant une pluralité de contacteurs (35a, 35b, 35c) pour connecter électriquement la carte de circuit (CB) et l'appareil d'inspection de carte de circuit, ledit procédé d'inspection de carte de circuit comprenant les étapes :
de mise à la masse d'un motif de câblage (P2) connecté électriquement au composant électronique de la carte de circuit (CB) par l'intermédiaire d'un contacteur (35c) de la pluralité de contacteurs de l'outil d'inspection de carte de circuit (32, 42), dans lequel une quantité de projection du contacteur (35c) est formée de manière à être plus grande qu'une quantité de projection des autres contacteurs (35a, 35b) de la pluralité de contacteurs ;
de réglage de tous les motifs de câblage (P1, P3, P4) autres que le motif de câblage mis à la masse (P2) parmi les motifs de câblage (P1, P2, P3, P4) formés sur la carte de circuit (CB) en contact conducteur avec l'appareil d'inspection de carte de circuit (1) par l'intermédiaire des autres contacteurs (35a, 35b) de l'outil d'inspection de carte de circuit (32, 42) ; et
de transmission et de réception d'un signal électrique par l'appareil d'inspection de carte de circuit (1), vers et à partir de la carte de circuit (CB) par l'intermédiaire de l'outil d'inspection de carte de circuit (1), effectuant de ce fait l'inspection électrique de la carte de circuit (CB).

2. Procédé d'inspection de carte de circuit selon la revendication 1, comprenant en outre les étapes :
après que l'inspection électrique a été effectuée, de mise à la masse de tous les motifs de câblage (P1, P2, P3, P4) formés sur la carte de circuit (CB), par l'appareil d'inspection de carte de circuit (1) par l'intermédiaire de la pluralité de contacteurs (35a, 35b, 35c) de l'outil d'inspection de carte de circuit (32, 42) ; et
de séparation de l'outil d'inspection de carte de circuit (1) de la carte de circuit (CB) dans un état dans lequel la pluralité de contacteurs (35a, 35b, 35c) sont mis à la masse.

3. Outil d'inspection de carte de circuit (32, 42) configuré pour connecter électriquement une carte de circuit (CB) avec un composant électronique (ED) intégré et un appareil d'inspection de carte de circuit (1) configuré pour inspecter une pluralité de motifs de câblage (P1, P2, P3, P4) formés sur la carte de circuit (CB), ledit outil d'inspection de carte de circuit (32, 42) comprenant :
une pluralité de contacteurs (35a, 35b, 35c) qui sont en butée sur des points d'inspection sur les motifs de câblage, à une extrémité ;
un corps d'électrodes (4) comportant des unités d'électrode sur lesquelles les contacteurs (35a, 35b, 35c) respectifs sont en butée à l'autre extrémité et qui sont connectées électriquement à l'appareil d'inspection de carte de circuit (1) ; et
un corps de maintien (3) comportant une unité de maintien côté inspection configurée pour guider les premières extrémités des contacteurs (35a, 35b, 35c) vers les points d'inspection et une unité de maintien côté électrode configurée pour guider les autres extrémités des contacteurs vers les unités d'électrode ; dans lequel
une quantité de projection d'un contacteur (35c) qui est en butée dans un état de mise à la masse sur un point d'inspection d'un motif de câblage (P2) connecté en conduction au composant électronique (ED) est formée de manière à être plus grande qu'une quantité de projection des autres contacteurs (35a, 35b) de sorte que le contacteur (35c) soit en butée sur le point d'inspection avant que les autres contacteurs (35a, 35b) soient en butée sur les autres points d'inspection.

4. Outil d'inspection de carte de circuit selon la revendication 3, dans lequel la quantité de projection du contact (35c) est fixée pour être plus grande que la quantité de projection des autres contacteurs (35b, 35c), d'une longueur qui est la somme d'une quantité de précision de taille des contacteurs (35a, 35b, 35c) et d'une quantité de déflexion de la carte de circuit (CB).

5. Outil d'inspection de carte de circuit selon la revendication 3 ou 4, dans lequel le motif de câblage (P2) connecté au composant électronique (ED) est connecté à une borne de masse du composant électronique (ED).

6. Appareil d'inspection de carte de circuit (1) configuré pour inspecter une pluralité de motifs de câblage (P1, P2, P3, P4) formés sur une carte de circuit (CB) avec un composant électronique (ED) intégré, ledit appareil d'inspection de carte de circuit (1) comprenant :
un outil d'inspection de carte de circuit (32, 42) selon la revendication 3 ou 4 pour connecter en conduction un motif de câblage (P1, P2, P3, P4) de la carte de circuit (CB) en tant qu'objet d'inspection et l'appareil d'inspection de carte de circuit (1) ;
un mécanisme de déplacement (30, 40) pour amener l'outil d'inspection de carte de circuit (32, 42) en butée sur la carte de circuit (CB) ;
un dispositif d'inspection (70) pour inspecter les caractéristiques électriques du motif de câblage (P1, P2, P3, P4) ; et
un dispositif de commande pour commander le mécanisme de déplacement (30, 40) et le dispositif d'inspection (70), dans lequel
le dispositif de commande active le mécanisme de déplacement (30, 40) pour amener l'outil d'inspection de carte de circuit (32, 42) en butée sur la carte de circuit (CB), et active le dispositif d'inspection (70) pour mettre à la masse le contacteur (35c) qui est en contact avec le motif de câblage (P2) connecté électriquement au composant électronique (ED).
